# EUROPEAN PATENT APPLICATION

(11) **EP 2 747 151 A2**
(43) Date of publication of application: **25.06.2014**
(21) Application number: 13193206.3
(22) Date of filing: 15.11.2013
(51) Int. Cl.: H01L 31/042

(54) **Apparatus for photovoltaic power generation**

(30) Priority: 24.12.2012 KR 20120152489
(71) Applicant: Samsung SDI Co., Ltd., Yongin-si, Gyeonggi-do (KR)
(72) Inventor: Jung, June-Hyuk, Chungcheongnam-do 331-300 (KR); Kim, Jong-Hwan, Gyeonggi-do (KR); Song, Nam-Kyu, Chungcheongnam-do 331-300 (KR); Park, Yong-Hee, Gyeonggi-do (KR)
(74) Representative: Mounteney, Simon James

(57) **Abstract**

A photovoltaic power generation apparatus including a photovoltaic power generator; a frame coupled to an edge of the photovoltaic power generator; and a holder coupled to the frame, the frame including a female coupling part coupled to the edge of the photovoltaic power generator, and a inserting part extending from the female coupling part and being inserted in the holder.

## Description

### BACKGROUND

### 1. Field

The present invention relates to an apparatus for photovoltaic power generation.

### 2. Description of the Related Art

Recently, as existing energy resources such as oil or coal are expected to be exhausted, an interest in alternative energy for replacing oil or coal is increasing. Among alternative energy sources, a solar cell, which directly converts solar energy into electric energy by using a semiconductor element, is getting attention as a next-generation cell.

Solar cells are devices which convert light energy into electric energy by using a photovoltaic effect. Solar cells may be classified into silicon solar cells, thin film solar cells, dye-sensitized solar cells, and organic polymer solar cells according to their components.

A photovoltaic power generation apparatus using solar cells includes an array constituted by connecting a plurality of solar cell modules in which solar cells are connected in series or parallel to each other. In the related art, a screw hole is processed in a frame of a solar cell module, and a connection plate having a matching hole corresponding to the screw hole is disposed between solar cell modules adjacent to each other. Then, the solar cell modules are connected through a screw assembly in which the matching hole is coupled to the screw hole to form an array. However, in the above-described method according to the related art, the process of forming the screw hole may be difficult. In addition, when the screw hole and the matching hole do not match each other, it is difficult to align the solar cell modules with each other.

### SUMMARY

The present invention, sets out to provide a photovoltaic power generation apparatus in which solar cell modules can be easily installed and aligned.

According to one or more embodiments of the present invention, a photovoltaic power generation apparatus includes: a photovoltaic power generator; a frame coupled to an edge of the photovoltaic power generator; and a holder coupled to the frame, the frame including a female coupling part coupled to the edge of the photovoltaic power generator, and a inserting part extending from the female coupling part and being inserted in the holder.

The holder may include a support part and a fixing part which define a receiving part, and the inserting part may be inserted in the receiving part.

The holder may further include a connection part connecting the support part to the fixing part.

The frame may further include a coupling protrusion on the inserting part, and the fixing part may surround an outer surface of the coupling protrusion.

The coupling protrusion may have a hemispherical shape.

The coupling protrusion may include a plurality of coupling protrusions arranged along a lengthwise direction of the frame.

The coupling protrusion may extend along a lengthwise direction of the frame.

The fixing part may have elasticity.

The holder may further include a hook protrusion on the support part, and the hook protrusion may be coupled to a hook formed in a surface of the inserting part contacting the support part.

Each of the hook protrusion and the hook may be provided in plurality.

According to one or more embodiments of the present invention, a photovoltaic power generation apparatus includes: a first solar cell module including a first photovoltaic power generator and a first frame coupled to an edge of the first photovoltaic power generator; a second solar cell module including a second photovoltaic power generator and a second frame coupled to an edge of the second photovoltaic power generator; and a holder coupled to the first and second solar cell modules, wherein the holder includes a support part, a first fixing part defining a first receiving part together with the support part, and a second fixing part defining a second receiving part together with the support part, the first and second fixing parts are arranged opposite to each other with respect to the support part, and the first solar cell module is inserted in the first receiving part, and the second solar cell module is inserted in the second receiving part.

The first frame may include a first inserting part inserted in the first receiving part, and the second frame may include a second inserting part inserted in the second receiving part.

The first frame may further include a first coupling protrusion on the first inserting part and inserted in the first receiving part, and the second frame may further include a second coupling protrusion on the second inserting part and inserted in the second receiving part.

Each of the first and second coupling protrusions may have a hemispherical shape.

Each of the first and second fixing parts may include an inner surface with a same radius of curvature as that of each of the first and second coupling protrusions.

The support part may include a first surface contacting the first inserting part, and a second surface contacting the second inserting part, and the support part may further include a first hook protrusion protruding from the first surface, and a second hook protrusion protruding from the second surface.

The first hook protrusion may be coupled to a first hook formed in the first inserting part contacting the first surface, and the second hook protrusion may be coupled to a second hook formed in the second inserting part contacting the second surface.

Each of the first and second fixing parts may have elasticity.

The first and second receiving parts may have different heights.

The holder may further include a connection part connecting the support part to the first and second fixing parts.

At least some of the above and other features of the invention are set out in the calims.

### BRIEF DESCRIPTION OF THE DRAWINGS

The above and/or other features and aspects of the present invention will become more apparent upon referring to embodiments thereof which are described below with reference to the attached drawings, in which:

FIG. 1 is a schematic cross-sectional view of a portion of a photovoltaic power generation apparatus according to an embodiment of the present invention;

FIG. 2 is an exploded perspective view of a photovoltaic power generator of the photovoltaic power generation apparatus of FIG. 1;

FIGS. 3A and 3B are views of a frame of the photovoltaic power generation apparatus of FIG. 1;

FIGS. 4A and 4B are views of a holder of the photovoltaic power generation apparatus of FIG. 1;

FIGS. 5A and 5B are views of a holder of a photovoltaic power generation apparatus, according to another embodiment of the present invention;

FIG. 6 is a perspective view of a portion of a photovoltaic power generation apparatus according to another embodiment of the present invention;

FIG. 7 is a perspective view of a portion of a photovoltaic power generation apparatus according to another embodiment of the present invention; and

FIG. 8 is a cross-sectional view of a portion of a photovoltaic power generation apparatus according to another embodiment of the present invention.

### DETAILED DESCRIPTION

Reference will now be made in further detail to some exemplary embodiments of the present invention, examples of which are illustrated in the accompanying drawings. However, the present invention may be embodied in different forms and should not be construed as limited to the embodiments illustrated and set forth herein. Rather, these described embodiments are provided by way of example for understanding of the invention to those skilled in the art. As those skilled in the art would realize, the described embodiments may be modified in various ways, all without departing from the scope of the present invention.

In the drawings, the thickness or size of each layer may be exaggerated, omitted, or schematically illustrated for convenience of description and clarity. Also, the size of each element does not necessarily reflect an actual size. In the description of embodiments, it will be understood that when a component is referred to as being "on" or "under" another component, the terminology "on" or "under" includes both the meanings of "directly" and "indirectly". Also, the terms "on" and "under" are used with reference to the drawings, but are not intended to be limiting. Like reference numerals in the drawings denote like elements.

Reference will now be made in further detail to some embodiments of the present invention, examples of which are illustrated in the accompanying drawings.

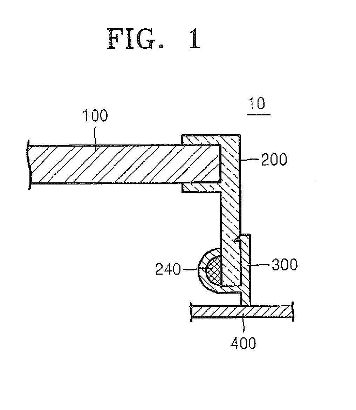

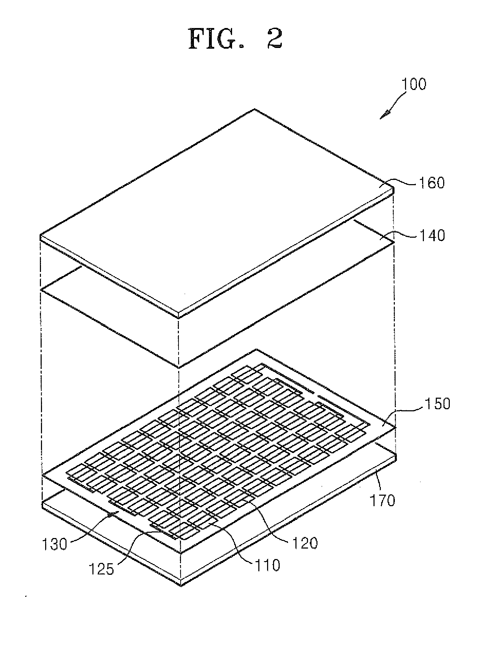

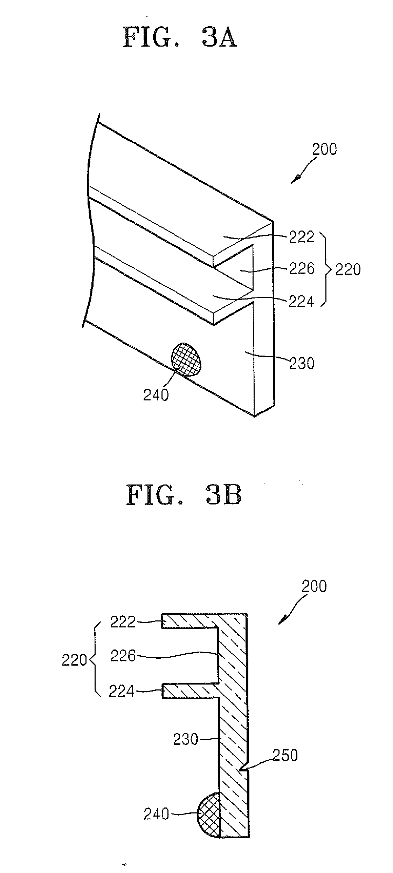

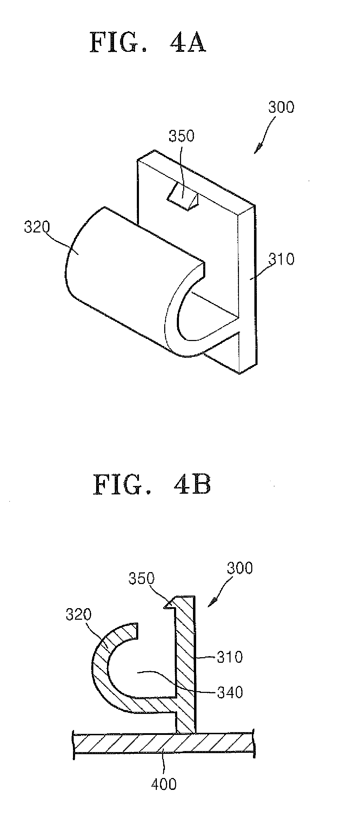

FIG. 1 is a schematic cross-sectional view of a portion of a photovoltaic power generation apparatus according to an embodiment of the present invention. FIG. 2 is an exploded perspective view of a photovoltaic power generator of the photovoltaic power generation apparatus of FIG. 1. FIGS. 3A and 3B are views of a frame of the photovoltaic power generation apparatus of FIG. 1. FIGS. 4A and 4B are views of a holder of the photovoltaic power generation apparatus of FIG. 1.

Referring to FIGS. 1 to 4, a photovoltaic power generation apparatus 10 according to an embodiment of the present invention includes a photovoltaic power generator 100, a frame 200 coupled to an edge of the photovoltaic power generator 100, and a holder 300 coupled to the frame 200.

The photovoltaic power generator 100 includes solar cells 110 which are semiconductor devices and directly convert solar energy into electric energy. The solar cells 110 may be silicon solar cells, compound semiconductor solar cells, dye-sensitized solar cells, or tandem solar cells. Hereinafter, the solar cells 110 that are silicon solar cells will be described as an example.

As shown in FIG. 2, the photovoltaic power generator 100, in one embodiment, may include a plurality of the solar cells 110, a ribbon 120 which electrically connects the solar cells 110 to each other to form a solar cell string 130, a first sealing film 140 and a front board 160 which are disposed above the plurality of solar cells 110, and a second sealing film 150 and a rear board 170 which are disposed below the plurality of solar cells 110.

The ribbon 120 electrically connects the plurality of solar cells 110 in series, parallel, or series/parallel to form the solar cell string 130. In one embodiment, the ribbon 120 may connect a front electrode disposed on a light-receiving surface of each solar cell 110 to a rear electrode disposed on a rear surface of another adjacent solar cell 110 through a tabbing process.

In the tabbing process, flux may be applied on one surface of the solar cell 110, the ribbon 120 may be disposed on the solar cell 110 coated with the flux, and then the resultant solar cell 110 may be plasticized. In another embodiment, a conductive film (not shown) may be attached between one surface of the solar cell 110 and the ribbon 120, and then the plurality of solar cells 110 may be connected in series or parallel to each other through a thermo compression process.

In one embodiment, the solar cell strings 130 may be electrically connected to each other by using a bus ribbon 125. The bus ribbon 125 may be disposed on both ends of the solar cell strings 130, which are parallel to each other, in a direction perpendicular to a length direction of the solar cell strings 130 to alternately connect both ends of the bus ribbons 125 of the solar cell strings 130 to each other. Although not shown, the bus ribbon 125 may be connected to a junction box (not shown) disposed on a rear surface of the photovoltaic power generator 100.

The first sealing film 140 is disposed on the light-receiving surface of the solar cell 110, and the second sealing film 150 is disposed on the rear surface of the solar cell 110. In one embodiment, the first sealing film 140 and the second sealing film 150 are adhered to each other through lamination to block moisture or oxygen which may adversely affect the solar cells 110.

In one embodiment, each of the first sealing film 140 and the second sealing film 150 may be formed of ethylene vinyl acetate (EVA) copolymer resin, polyvinyl butyral, ethylene vinyl acetate partial oxide, silicon resin, ester-based resin, or olefin-based resin.

The front board 160 is disposed on the first sealing film 140. The front board 160 may be formed of glass having superior light transmittance or a polymer material. Also, to protect the solar cells 110 from an external impact, the front board 160 may be formed of tempered glass. In one embodiment, to prevent or substantially prevent solar light from being reflected and increase light transmittance, the front board 160 may be formed of low-iron tempered glass having a low iron concentration.

The rear board 170 may be disposed on the rear surface of the solar cell 110 to protect the solar cell 110. The rear board 170 may have waterproofing, insulation, and anti-ultraviolet functions. In one embodiment, the rear board 170 may be formed by stacking a polyvinyl fluoride sheet, a polyethylene terephthalate sheet, and a polyvinyl fluoride sheet, but the present invention is not limited thereto.

The frame 200 may be coupled to an edge of the photovoltaic power generator 100 to form a solar cell module together with the photovoltaic power generator 100. The frame 200 is coupled to the holder 300.

FIG. 3A is a perspective view of the frame 200. FIG. 3B is a side sectional view of the frame 200. The frame 200, in one embodiment, includes a female coupling part 220 coupled to the photovoltaic power generator 100, and a inserting part 230 extending from the female coupling part 220.

The female coupling part 220, in one embodiment, includes an upper coupling unit 222, a lower coupling unit 224, and a connection coupling unit 226 connecting the upper coupling unit 222 to the lower coupling unit 224 to define a rectangular or generally rectangular shape. The photovoltaic power generator 100 is coupled to the female coupling part 220.

Although not shown, a coupling part (not shown) formed of a material having elasticity may be disposed on an edge of the photovoltaic power generator 100 coupled to the female coupling part 220. For example, the coupling part (not shown) on an edge of the photovoltaic power generator 100 may be a tape formed of a material having elasticity, but is not limited thereto. The coupling part (not shown) on an edge of the photovoltaic power generator 100 may securely couple the photovoltaic power generator 100 to the female coupling part 220 and prevent or substantially prevent external foreign matter from being introduced into the photovoltaic power generator 100.

The inserting part 230 extends from the female coupling part 220. Also, the inserting part 230 is coupled to the holder 300 to support the photovoltaic power generator 100 coupled to the female coupling part 220.

In one embodiment, a coupling protrusion 240 is disposed on the inserting part 230. Also, a hook 250 may be disposed in a surface opposite to that on which the coupling protrusion 240 is disposed.

The coupling protrusion 240 protrudes from the inserting part 230. In one embodiment, the coupling protrusion 240 may have a hemispherical shape, as shown in FIGS. 3A and 3B. However, the present invention is not limited thereto. In other embodiments, for example, the coupling protrusion 240 may have various shapes. The coupling protrusion 240 may be integrated with the inserting part 230. In one embodiment, the coupling protrusion 240 may be formed of the same material as that of the inserting part 230. Alternatively, the coupling protrusion 240 may be formed of a material different from that of the inserting part 230. In one embodiment, for example, the coupling protrusion 240 may be formed of a material having elasticity, such as rubber, and may be coupled to the inserting part 230.

The hook 250 may have, for example, a right-angled triangular cross-sectional shape. In one embodiment, the hook 250 may be a groove formed in a surface of the inserting part 230.

The inserting part 230 may be inserted into the holder 300 and fit into the holder 300.

FIG. 4A is a perspective view of the holder 300. FIG. 4B is a side cross-sectional view of the holder 300. The holder 300, in one embodiment, may include a support part 310 and a fixing part 320, together defining a receiving part 340. The support part 310 and the fixing part 320 may be integrated with each other. The support part 310 may be fixed to a support plate 400 disposed at a location at which the solar cell module is installed. The support part 310 may contact the inserting part 230 of the frame 200 to support the inserting part 230. In one embodiment, a hook protrusion 350 is disposed on a surface of the support part 310 contacting the inserting part 230.

The hook protrusion 350 protrudes toward the receiving part 340. The hook protrusion 350 may have a shape matching the hook 250 disposed in the inserting part 230. That is, the hook protrusion 350 may have a right-angled triangular cross-sectional shape. The hook protrusion 350 may protrude from the support part 310.

The fixing part 320, in one embodiment, extends from the support part 310. The fixing part 320 may have high elasticity and surround an outer surface of the coupling protrusion 240 disposed on the inserting part 230. In one embodiment, for example, in which the coupling protrusion 240 has a hemispherical shape, the fixing part 320 may have an inner surface with a same curvature as that of the coupling protrusion 240.

A method of coupling the holder 300 and the frame 200 is described further below.

When the inserting part 230 of the frame 200 coupled to the photovoltaic power generator 100 is inserted into the receiving part 340 of the holder 300, the fixing part 320 having elasticity may be pushed outward by the coupling protrusion 240 disposed on the inserting part 230.

Then, when the inserting part 230 and the coupling protrusion 240 are inserted in the receiving part 340, the fixing part 320 may be restored to its original state by an elastic force to surround an outer surface of the coupling protrusion 240. Additionally, the hook protrusion 350 disposed on the support part 310 is coupled to the hook 250 disposed in the surface of the inserting part 230 contacting the support part 310. The hook protrusion 350 and the hook 250 prevent or substantially prevent the inserting part 230 from being separated from the holder 300.

Thus, according to embodiments of the present invention, the inserting part 230 of the frame 200 may be simply inserted and fit into the holder 300 to easily install the solar cell module. In addition, the separation of the solar cell module may be effectively prevented or substantially prevented.

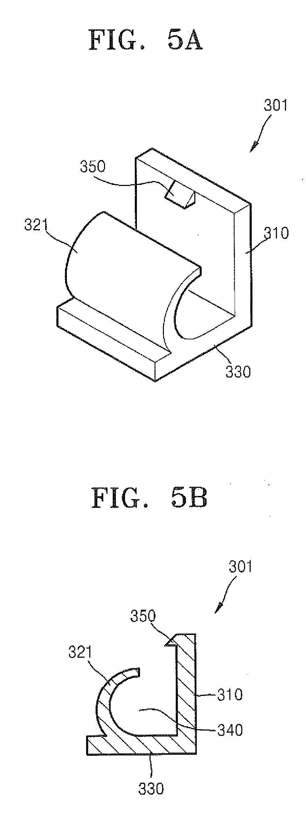

FIGS. 5A and 5B are views of a holder of a photovoltaic power generation apparatus, according to another embodiment of the present invention.

Referring to FIGS. 5A and 5B, a holder 301 according to another embodiment of the present invention includes a connection part 330 connecting the support part 310 to a fixing part 321, and is otherwise similar to the holder 300 described above with respect to FIGS. 4A and 4B. The connection part 330 may be integrated with the support part 310 and the fixing part 321. The support part 310 and the fixing part 321 may be disposed on the connection part 330. Also, the fixing part 321 and the support part 310 may be spaced apart from each other to define the receiving part 340.

In one embodiment, the connection part 330 may be directly installed on the ground or a roof on which the solar cell module is disposed, and the support plate 400 described above with respect to the holder 300 may be omitted in the holder 301. Thus, the holder 301 may be easily installed.

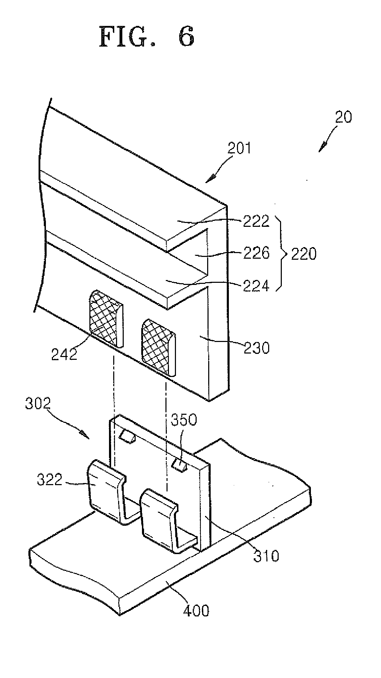

FIG. 6 is a perspective view of a portion of a photovoltaic power generation apparatus according to another embodiment of the present invention.

Referring to FIG. 6, a photovoltaic power generation apparatus 20 according to another embodiment of the present invention includes a frame 201 coupled to an edge of a photovoltaic power generator (not shown), and a holder 302 coupled to the frame 201.

The frame 201, in one embodiment, includes the female coupling part 220 and the inserting part 230 extending from the female coupling part 220, and the female coupling part 220 includes the upper coupling unit 222, the lower coupling unit 224, and the connection coupling unit 226 connecting the upper coupling unit 222 to the lower coupling unit 224.

A plurality of coupling protrusions 242 is disposed on the inserting part 230. The coupling protrusions 242 protrude from a surface of the inserting part 230. The coupling protrusions 242 may be spaced by a distance (e.g., a predetermined distance) from each other in a lengthwise direction of the frame 201. Although two coupling protrusions 242 are shown in FIG. 6 as an example, the present invention is not limited thereto. In one embodiment, each of the coupling protrusions 242 may have a rectangular or generally rectangular shape and may also have smoothly curved edge portions. However, the present invention is not limited thereto.

The holder 302 may include the support part 310 and a plurality of fixing parts 322 coupled to the support part 310. In one embodiment, a number of the fixing parts 322 may correspond to that of the coupling protrusions 242. The fixing parts 322 may respectively surround outer surfaces of the coupling protrusions 242.

The holder 302 may include a number of the hook protrusions 350 disposed on the support part 310 corresponding to that of coupling protrusions 242, but the present invention is not limited thereto.

Thus, when the inserting part 230 is coupled to the holder 302, the plurality of coupling protrusions 242 may be inserted and fit into the holder 302 to improve coupling between the inserting part 230 and the holder 302.

In one embodiment, the holder 302 has a same or similar configuration as that of the holder 300 described above with respect to FIGS. 4A and 4B. However, the present invention is not limited thereto. In another embodiment, for example, the holder 302 may include a connection part similar to the connection part 330 of the holder 301 described above with respect to FIGS. 5A and 5B.

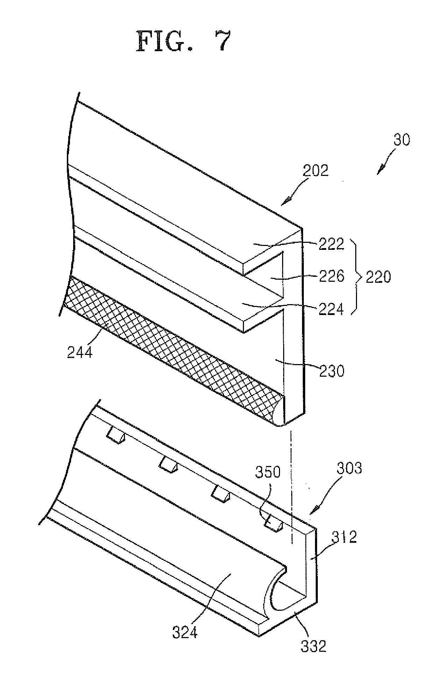

FIG. 7 is a perspective view of a portion of a photovoltaic power generation apparatus according to another embodiment of the present invention.

Referring to FIG. 7, a photovoltaic power generation apparatus 30 according to another embodiment of the present invention includes a frame 202 coupled to an edge of a photovoltaic power generator (not shown), and a holder 303 coupled to the frame 202.

The frame 202, in one embodiment, includes the female coupling part 220 and the inserting part 230 extending from the female coupling part 220, and the female coupling part 220 includes the upper coupling unit 222, the lower coupling unit 224, and the connection coupling unit 226 connecting the upper coupling unit 222 to the lower coupling unit 224.

A coupling protrusion 244 is disposed on the inserting part 230. The coupling protrusion 244, in one embodiment, protrudes from a surface of the inserting part 230 and extends along a lengthwise direction of the frame 202.

The holder 303 may have a length corresponding to that of the frame 202. In one embodiment, the holder 303 may include a connection part 332 fixed to a place at which a photovoltaic power generator (not shown) is installed, a support part 312 disposed on the connection part 332, and a fixing part 324. Each of the support part 312 and the fixing part 324 may have a length corresponding to that of the frame 202 and extend along the lengthwise direction of the frame 202.

A plurality of hook protrusions 350 may be disposed on the support part 312. The hook protrusions 350 may be spaced by a distance (e.g., a predetermined distance) from each other along the support part 312 extending in the lengthwise direction of the frame 202. Also, a plurality of hooks (not shown) disposed on the inserting part 230 and coupleable to the hook protrusions 350 may be provided to correspond to the number of hook protrusions 350.

In another embodiment, one hook protrusion disposed on the support part 312 may be longitudinally disposed along the support part 312 extending in the lengthwise direction of the frame 202.

Thus, when the coupling protrusion 244 is inserted and fit into the holder 303, a coupling force therebetween may be improved.

In one embodiment, the holder 303 is modified from, or similar to, the holder 301 described above with respect to FIGS. 5A and 5B. However, the present invention is not limited thereto. In another embodiment, for example, the holder 303 may have a same or similar configuration as that of the holder 300 described above with respect to FIGS. 4A and 4B.

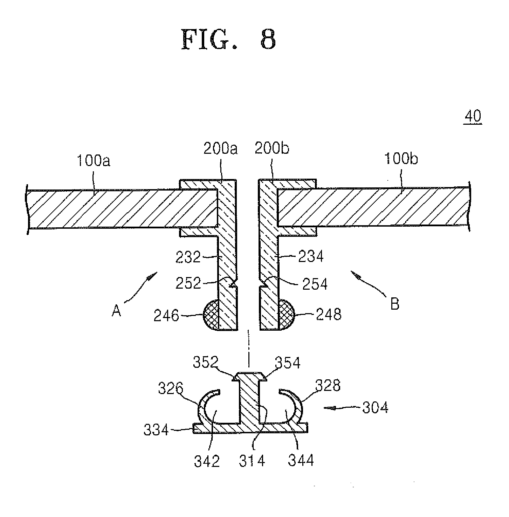

FIG. 8 is a cross-sectional view of a portion of a photovoltaic power generation apparatus according to another embodiment of the present invention.

A photovoltaic power generation apparatus 40 according to another embodiment of the present invention includes a first solar cell module "A" including a first photovoltaic power generator 100a and a first frame 200a coupled to an edge of the first photovoltaic power generator 100a, a second solar cell module "B" including a second photovoltaic power generator 100b and a second frame 200b coupled to an edge of the second photovoltaic power generator 100b, and a holder 304 coupled to the first solar cell module "A" and the second solar cell module "B."

In one embodiment, the first and second photovoltaic power generators 100a and 100b are the same as the photovoltaic power generator 100 described above with respect to FIGS. 1 and 2. Also, the first and second frames 200a and 200b may be the same as the frame 200 described above with respect to FIGS. 3A and 3B. Thus, further description thereof will not be repeated.

Referring to FIG. 8, the holder 304, in one embodiment, includes a connection part 334, a support part 314 disposed on the connection part 334, and first and second fixing parts 326 and 328 disposed on the connection part 334.

The connection part 334 may be fixed to the ground or a roof, for example, on which the first and second solar cell modules "A" and "B" are installed, such as by a bolt.

The support part 314 may be disposed on the connection part 334. The support part 314 may include a first hook protrusion 352 disposed on a first surface and a second hook protrusion 354 disposed on a second surface opposite to the first surface. Each of the first and second hook protrusions 352 and 354 may have a right-angled triangular cross-sectional shape. The first and second hook protrusions 352 and 354 may protrude from the first and second surfaces, respectively.

Each of the first and second fixing parts 326 and 328 may have elasticity. Also, the first and second fixing parts 326 and 328 may be disposed opposite to each other with respect to the support part 314. For example, when each of a first coupling protrusion 246 of the first frame 200a and a second coupling protrusion 248 of the second frame 200b has a hemispherical shape, each of the first and second fixing parts 326 and 328 may have an inner surface with a same radius of curvature as that of each of the first and second coupling protrusions 246 and 248.

The support part 314 and the first fixing part 326 together define a first receiving part 342 to be coupled to the first solar cell module "A," and the support part 314 and the second fixing part 328 together define a second receiving part 344 to be coupled to the second solar cell module "B."

The first frame 200a includes a first inserting part 232 including the first coupling protrusion 246 and a first hook 252. The first inserting part 232 may be inserted and fit into the first receiving part 342. That is, when the first inserting part 232 is inserted into the first receiving part 342, the first fixing part 326 may surround an outer surface of the first coupling protrusion 246, and the first hook protrusion 352 disposed on the first surface of the support part 314 contacting the first inserting part 232 may be coupled to the first hook 252. Thus, the first solar cell module "A" may be easily installed.

Similarly, the second frame 200b includes a second inserting part 234 including the second coupling protrusion 248 and a second hook 254. The second inserting part 234 may be inserted and fit into the second receiving part 344. Thus, the second solar cell module "B" may be easily installed.

Therefore, since the two solar cell modules "A" and "B" are coupled to the one holder 304 at the same time, the solar cell modules "A" and "B" may be easily installed and aligned.

The first and second receiving parts 342 and 344 may be symmetrical to each other with respect to the support part 314. That is, the first and second receiving parts 342 and 344 may have a same height. In this case, the first and second solar cell modules "A" and "B" may be installed at a same height.

According to another embodiment, the first and second receiving parts 342 and 344 may have different heights. For example, when the connection part 334 defining the first receiving part 342 has a thickness different from that of the connection part 334 defining the second receiving part 344, the first and second solar cell modules "A" and "B" may be installed with a height difference therebetween. Thus, the first and second solar cell modules "A" and "B" may be easily installed on an inclined location, such as an inclined roof.

Although the holder 304, in one embodiment, may have a configuration similar to that of the holder 301 described above with respect to FIGS. 5A and 5B, the present invention is not limited thereto. In another embodiment, for example, the holder 304 of the photovoltaic power generation apparatus 40 may have a configuration similar to that of the holder 300 described above with respect to FIGS. 4A and 4B.

As described above, in a photovoltaic power generation apparatus according to one or more embodiments of the present invention, solar cell modules are easily installed and aligned.

In a photovoltaic power generation apparatus according to the present invention, portions or all of the above-described embodiments may be selectively combined and constructed such that various modifications are possible, without the construction and scheme of the above-described embodiments being limited.

While the present invention has been particularly shown and described with reference to some exemplary embodiments thereof, it will be understood by those of ordinary skill in the art that various changes in form and details may be made therein without departing from the spirit and scope of the present invention as defined by the following claims. Descriptions of features or aspects within each embodiment should typically be considered as available for other similar features or aspects in other embodiments.

## Claims

1. A photovoltaic power generation apparatus comprising:
a photovoltaic power generator;
a frame coupled to an edge of the photovoltaic power generator; and
a holder coupled to the frame,
wherein the frame comprises a female coupling part coupled to the edge of the photovoltaic power generator, and an inserting part extending from the female coupling part and inserted in the holder.

2. A photovoltaic power generation apparatus according to claim 1, wherein the holder comprises a support part and a fixing part which define a receiving part, and the inserting part is inserted in the receiving part.

3. A photovoltaic power generation apparatus according to claim 2, wherein the holder further comprises a connection part connecting the support part to the fixing part.

4. A photovoltaic power generation apparatus according to claim 2 or 3, wherein the frame further comprises a coupling protrusion on the inserting part, and the fixing part surrounds an outer surface of the coupling protrusion.

5. A photovoltaic power generation apparatus according to claim 4, comprising a plurality of said coupling protrusions arranged along a lengthwise direction of the frame.

6. A photovoltaic power generation apparatus according to claim 4 or 5wherein the coupling protrusion extends along a lengthwise direction of the frame.

7. A photovoltaic power generation apparatus according to claim 2 or any claim dependent on claim 2, wherein the holder further comprises a hook protrusion on the support part, and the hook protrusion is coupled to a hook formed in a surface of the inserting part contacting the support part.

8. A photovoltaic power generation apparatus comprising:
a first solar cell module comprising a first photovoltaic power generator and a first frame coupled to an edge of the first photovoltaic power generator;
a second solar cell module comprising a second photovoltaic power generator and a second frame coupled to an edge of the second photovoltaic power generator; and
a holder coupled to the first and second solar cell modules,
wherein the holder comprises a support part, a first fixing part defining a first receiving part together with the support part, and a second fixing part defining a second receiving part together with the support part,
wherein the first and second fixing parts are arranged opposite to each other with respect to the support part, and
wherein the first solar cell module is inserted in the first receiving part, and the second solar cell module is inserted in the second receiving part.

9. A photovoltaic power generation apparatus according to claim 8, wherein the first frame comprises a first inserting part inserted in the first receiving part, and the second frame comprises a second inserting part inserted in the second receiving part.

10. A photovoltaic power generation apparatus according to claim 9,
wherein the first frame further comprises a first coupling protrusion on the first inserting part and inserted in the first receiving part, and
wherein the second frame further comprises a second coupling protrusion on the second inserting part and inserted in the second receiving part.

11. A photovoltaic power generation apparatus according to claim 10, wherein each of the first and second coupling protrusions has a hemispherical shape.

12. A photovoltaic power generation apparatus according to claim 11, wherein each of the first and second fixing parts comprises an inner surface with a same radius of curvature as that of each of the first and second coupling protrusions.

13. A photovoltaic power generation apparatus according to claim 9, 10, 11 or 12,
wherein the support part comprises a first surface contacting the first inserting part, and a second surface contacting the second inserting part, and
wherein the support part further comprises a first hook protrusion protruding from the first surface, and a second hook protrusion protruding from the second surface.

14. A photovoltaic power generation apparatus according to claim 13, wherein the first hook protrusion is coupled to a first hook formed in the first inserting part contacting the first surface, and the second hook protrusion is coupled to a second hook formed in the second inserting part contacting the second surface.

15. A photovoltaic power generation apparatus according to one of claims 11 to 14, wherein the first and second receiving parts have different heights.

16. A photovoltaic power generation apparatus according to one of claims 11 to 15, wherein the holder further comprises a connection part connecting the support part to the first and second fixing parts.
